# EUROPEAN PATENT APPLICATION

(11) **EP 1 146 545 A1**
(43) Date of publication of application: **17.10.2001**
(21) Application number: 00830268.9
(22) Date of filing: 10.04.2000
(51) Int. Cl.: H01L 21/00

(54) **Wafer supporting device**

(71) Applicant: STMicroelectronics S.r.l., 20041 Agrate Brianza (Milano) (IT)
(72) Inventor: Pocorobba, Concetto, 94015 Piazza Armerina (Prov. of Enna) (IT); Grasso, Gianleonardo, 95016 Mascali (Prov. of Catania) (IT)
(74) Representative: Modiano, Guido, Dr.-Ing.

(57) **Abstract**

A silicon wafer supporting device, for the evaporation of the wafer backside, comprising a plate-like element (10); its particularity consists of the fact that it comprises at least one blind seat (11) which is formed at the lower surface of the plate-like element (10) and is adapted to accommodate at least one silicon wafer (2) whose lower side must be subjected to a metallization process, a plurality of bracket-like elements (12) being rigidly fixed to the plate-like element (10) and being adapted to support the at least one silicon wafer (2) at its perimeter.

## Description

The present invention relates to a silicon wafer supporting device, for the evaporation of the wafer backside.

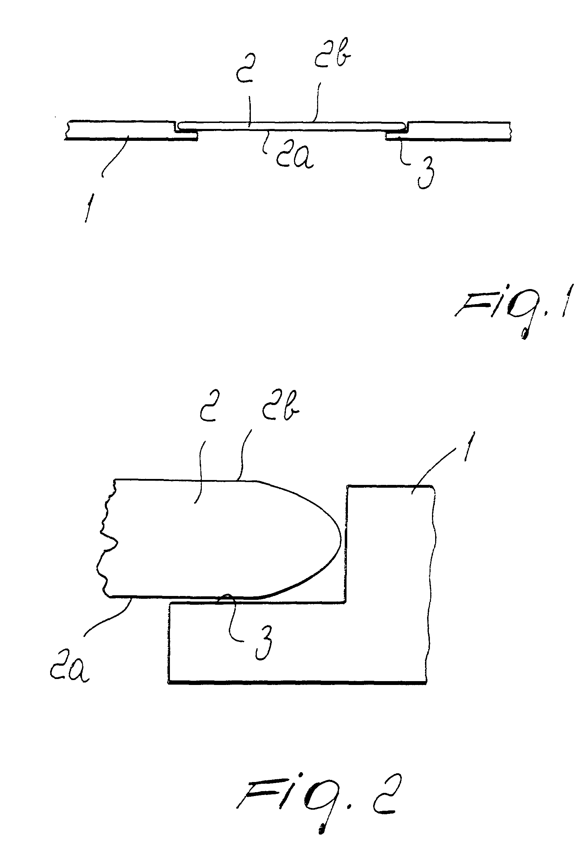

It is known that silicon wafers that must be subjected to evaporation of the wafer backside in order to allow their metallization are supported on supporting devices of the perimetric type, schematically designated by the reference numeral 1 in Figure 1. These supporting devices have a plurality of through openings in which the silicon wafers 2 whose backside is to be subjected to evaporation are arranged.

Conveniently, the silicon wafers 2 are supported by laterally protruding portions 3 of the through cavities, and accordingly the result is that the silicon wafer 2 is exposed as regards both its backside (which is to be subjected to evaporation) and its front side, which should instead be kept unchanged.

During the evaporation process, the direction of the evaporation stream, shown by the arrows 4 in Figure 1, is such as to affect not only the backside 2a of the silicon wafer 2 but also its front side 2b, with undesirable effects.

Moreover, the fact that the silicon wafer 2 is supported by the step-shaped protruding portions 3 of the perimetric supporting device 1 prevents the evaporation process of the backside of the silicon wafer 2 from occurring at said regions, thus leaving a non-metallized annular region of a certain thickness.

Figure 2 is a detail view of the region where the silicon wafer 2 rests on the protruding part 3 of the perimetric supporting device 1.

Moreover, the conventional supporting devices 1 are generally made of steel and are subject to losses of mechanical performance due to the deformation to which they are inevitably subjected.

The aim of the present invention is to provide a silicon wafer supporting device, for the evaporation of the wafer backside, which allows to avoid unwanted metallic contamination of the front side of the silicon wafer.

Within the scope of this aim, an object of the present invention is to provide a silicon wafer supporting device which makes substantially negligible the non-metallized region of the backside of the silicon wafer.

Another object of the present invention is to provide a silicon wafer supporting device which can be substantially non-deformable, thus maintaining its initial mechanical characteristics.

Another object of the present invention is to provide a silicon wafer supporting device in which the silicon wafers are not affected by loss of electrical performance.

Another object of the present invention is to provide a silicon wafer supporting device which is highly reliable, relatively simple to provide and at competitive costs.

This aim, these objects and others which will become better apparent hereinafter are achieved by a silicon wafer supporting device, for the evaporation of the wafer backside, which comprises a plate-like element, characterized in that it comprises at least one blind seat which is formed at the lower surface of said plate-like element, said blind seat being adapted to accommodate at least one silicon wafer whose lower side must be subjected to a metallization process, a plurality of bracket-like elements being rigidly fixed to said plate-like element and being adapted to support said at least one silicon wafer at its perimeter.

Further characteristics and advantages of the present invention will become better apparent from the description of a preferred but not exclusive embodiment of the supporting device according to the invention, illustrated only by way of non-limitative example in the accompanying drawings, wherein:
Figure 1 is a schematic partial view of a conventional supporting device;
Figure 2 is a detail view of the conventional supporting device of Figure 1;
Figure 3 is a schematic view of a supporting device according to the present invention;
Figure 4 is a detail view of the supporting device according to the invention, shown in Figure 1;
Figure 5 is a plan view of one of the blind seats formed in the supporting device according to the invention;
Figure 6 is a partial sectional view, taken along the plane VI-VI of Figure 5; and
Figure 7 is a view of one of the silicon wafer supporting brackets used in the supporting device according to the invention.

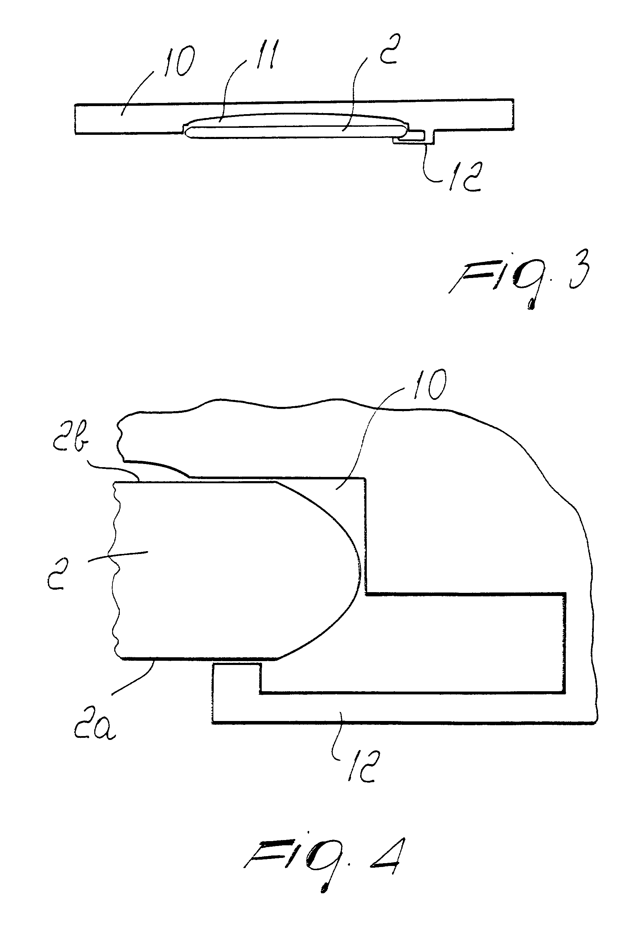

With reference to the above figures, in which identical reference numerals designate identical elements, and particularly with reference to Figures 2 to 7, the supporting device according to the invention, designated by the reference numeral 10 and constituted by a plate-like element, has at least one blind seat 11 which is adapted to accommodate at least one silicon wafer 2. The silicon wafer 2 is conveniently supported within the seat 11 by a plurality of bracket-like elements 12, which are fixed to the supporting device 10 so as to protrude at least partially into the blind seat 11, so as to act as a support for the silicon wafer 2.

In any case, as shown in Figure 4, the portion of the silicon wafer 2 that makes contact with the bracket-like element 12 is reduced with respect to the contact region of the silicon wafer 2 shown in Figure 2.

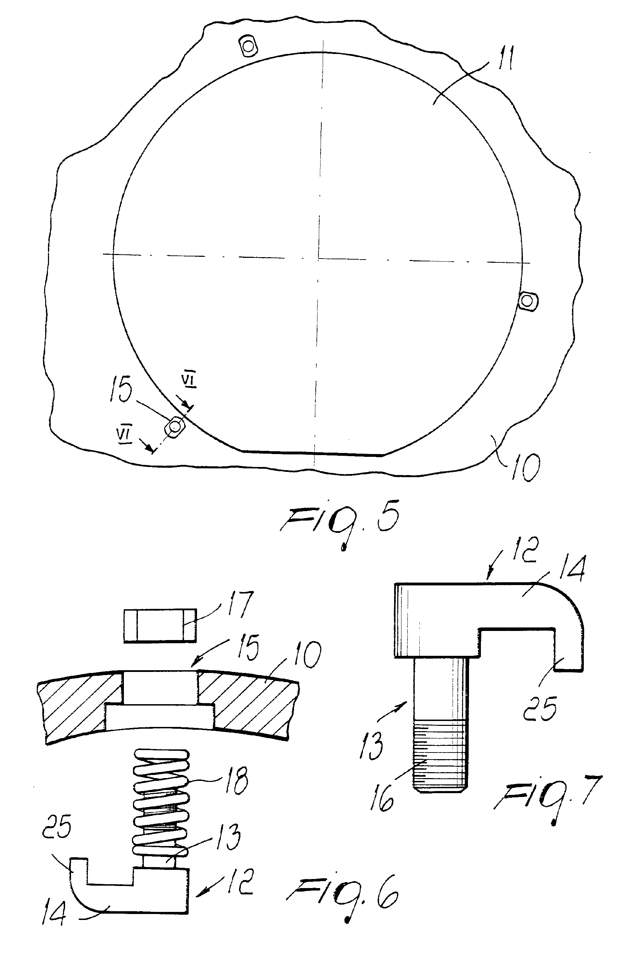

Bracket-like elements 12, for example conveniently three elements arranged with a mutual offset of 120°, are fixed to the supporting device 10 by anchoring in appropriate seats 15, which are shown in cross-section in Figure 6.

Each seat 15 formed in the thickness of the supporting device 10 is conveniently step-shaped, so as to form two portions having different diameters which are adapted to accommodate the bracket-like element 12.

As shown in Figure 7, the bracket-like element 12 is conveniently substantially L-shaped, the vertical portion of L, designated by the reference numeral 13, being adapted to engage in the seat 15, while the horizontal portion 14 is adapted to constitute the supporting element for the silicon wafer 2.

In particular, the portion 14 of the bracket-like element 12 has a raised part 2 whose axis is parallel to the axis of the portion 13 and allows the silicon wafer to rest thereon.

Therefore, the circumferential portion of the silicon wafer that is not affected by the metallization process is only the portion that rests on the thickness of the vertical portion 2 of the bracket-like element 12.

The bracket-like element 12 conveniently has, at the upper end portion of the portion 13, a thread 16 which allows the engagement of a locking nut 17 which is designed to fasten the bracket-like element 12 within the seat 15, with elastic means interposed; said elastic means are conveniently constituted, for example, by a helical spring 18.

In this manner, therefore, a silicon wafer 2 is accommodated from below in a blind seat 11 formed within the supporting device 10 so that the upper surface 2b of the silicon wafer 2 is screened by the supporting device 10, i.e., by the portion of the device below which the blind seat 11 is formed. The backside 2a of the silicon wafer is instead exposed to the metallization process that affects the silicon wafer, and said silicon wafer rests exclusively on the thickness of the portion 25 of the bracket-like element 12. Conveniently, as mentioned, there are a plurality of bracket-like elements 12 (for example three) in order to adequately support the silicon wafer 2 inside the blind seat 11.

In this manner, differently from conventional supporting devices, the use of a perimetric supporting device according to the invention allows to avoid metallic contamination of the front side 2b of the silicon wafer 2, in addition to avoiding excessive lack of metallization on the backside 2a, at the resting regions of the silicon wafer.

Additionally, the supporting device 10 is conveniently made of titanium, so as to have better mechanical characteristics than conventional perimetric supporting devices, which are made of steel.

Also owing to the fact that there are no through seats but only blind seats 11, the supporting device according to the invention ensures substantial non-deformability, with constant mechanical performance over time.

In practice it has been observed that the supporting device according to the invention fully achieves the intended aim and objects.

The device thus conceived is susceptible of numerous modifications and variations, all of which are within the scope of the inventive concept; all the details may furthermore be replaced with other technically equivalent elements.

In practice, the materials used, so long as they are compatible with the specific use, may be any according to requirements and to the state of the art.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. A silicon wafer supporting device, for the evaporation of the wafer backside, comprising a plate-like element, **characterized in that** it comprises at least one blind seat which is formed at the lower surface of said plate-like element, said blind seat being adapted to accommodate at least one silicon wafer whose lower side must be subjected to a metallization process, a plurality of bracket-like elements being rigidly fixed to said plate-like element and being adapted to support said at least one silicon wafer at its perimeter.

2. The device according to claim 1, **characterized in that** said plurality of bracket-like elements are rigidly fixed to said plate-like element, so as to protrude from the lower side of said plate-like element and protrude at least partially into said blind seat.

3. The device according to claim 1, **characterized in that** each one of said bracket-like elements is substantially L-shaped, the horizontal portion of said bracket-like element having, at its free end, a vertical portion which is adapted to constitute a resting base for said silicon wafer.

4. The device according to claim 3, **characterized in that** said bracket-like element comprises a vertical portion which is adjacent to the horizontal portion and is substantially parallel to the vertical portion adapted to support said silicon wafer, said vertical portion adjacent to the horizontal portion being adapted to engage in a seat formed in said plate-like element.

5. The device according to claim 4, **characterized in that** said bracket-like element is rigidly connected to said plate-like element by engagement in said seat by means of a nut with interposed elastic means.

6. The device according to claim 1, **characterized in that** said plate-like element is made of titanium.

7. The device according to claim 1, **characterized in that** it comprises a plurality of blind seats which are adapted to accommodate a plurality of silicon wafers.
